(19) **Europäisches Patentamt / European Patent Office / Office européen des brevets**

(11) **EP 3 529 897 B1**

(12) **FASCICULE DE BREVET EUROPEEN**

(45) Date de publication et mention de la délivrance du brevet:
**23.09.2020 Bulletin 2020/39**

(21) Numéro de dépôt: **17783529.5**

(22) Date de dépôt: **17.10.2017**

(51) Int Cl.:
*H03K 17/06* (2006.01)    *H02M 1/08* (2006.01)
*H03K 17/691* (2006.01)    *H03K 17/687* (2006.01)

(86) Numéro de dépôt international:
**PCT/EP2017/076405**

(87) Numéro de publication internationale:
**WO 2018/073204 (26.04.2018 Gazette 2018/17)**

(54) **DISPOSITIF DE COMMANDE D'UN TRANSISTOR**

VORRICHTUNG ZUR STEUERUNG EINES TRANSISTORS

DEVICE FOR CONTROLLING A TRANSISTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.10.2016 FR 1601507**

(43) Date de publication de la demande:
**28.08.2019 Bulletin 2019/35**

(73) Titulaire: **Thales**
**92400 Courbevoie (FR)**

(72) Inventeurs:
- **LE BARS, David**
  **29238 Brest Cedex 3 (FR)**
- **MOREL, Benoît**
  **29238 Brest Cedex 3 (FR)**
- **STEPHAN, Hervé**
  **29238 Brest Cedex 3 (FR)**
- **SEGONNES, Sébastien**
  **29238 Brest Cedex 3 (FR)**

(74) Mandataire: **Lavoix**
**2, place d'Estienne d'Orves**
**75441 Paris Cedex 09 (FR)**

(56) Documents cités:
DE-A1- 3 243 660    US-A- 5 910 746
US-A- 6 094 087    US-A1- 2002 175 719
US-A1- 2010 072 971    US-A1- 2011 222 316
US-B1- 6 496 047

- **BALOGH L: "Design and application guide for high speed MOSFET gate drive circuits", INTERNET CITATION, 1 janvier 2001 (2001-01-01), pages 1-37, XP002552367, Extrait de l'Internet: URL:http://focus.ti.com/lit/ml/slup169/slu p169.pdf [extrait le 2009-10-26]**
- **LOVATT H C ET AL: "DESIGN OF A 3-PHASE, MOSFET INVERTER AND ASSOCIATED GATE-DRIVE CIRCUIT", PROCEEDINGS OF THE EUROPEAN CONFERENCE ON POWER ELECTRONICS AND APPLICATIONS. (EPE). AACHEN, 9 - 12 OCTOBER, 1989, DUSSELDORF, EPE SECRETARIAT, DE, vol. 1, 9 octobre 1989 (1989-10-09), pages 165-169, XP000143384,**

EP 3 529 897 B1

## Description

La présente invention concerne un dispositif de commande d'un transistor. La présente invention se rapporte également à un convertisseur comprenant un transistor et un tel dispositif de commande du transistor. La présente invention se rapporte aussi à un système embarqué comprenant un tel convertisseur.

Dans le cadre du développement des convertisseurs de courant, l'utilisation des transistors MOSFET (acronyme de l'anglais *Metal Oxide Semiconductor Field Effect Transistor* traduit en français par *Transistor à effet de champ à structure métal-oxyde-semiconducteur*) en carbure de silicium permet d'améliorer les performances de tels convertisseurs. En particulier, les transistors MOSFET en carbure de silicium permettent d'obtenir des convertisseurs remplissant plusieurs fonctions de conversion au sein d'une même carte. En outre, de tels transistors permettent d'obtenir un meilleur rendement par rapport aux transistors MOSFET en silicium.

Cependant, les circuits de pilotage actuels s'avèrent inadaptés pour le pilotage des transistors en carbure de silicium. En particulier, de tels circuits de pilotage présentent généralement une tension de pilotage symétrique qui est susceptible d'endommager les transistors en carbure de silicium.

Le document DE3243660 A1 divulgue un dispositif de commande d'un transistor selon l'état de la technique.

Il existe donc un besoin pour un dispositif de commande adapté pour commander tous types de transistors, notamment des transistors en carbure de silicium, sans risquer de détériorer le transistor commandé par ledit dispositif.

A cet effet, l'invention a pour objet un dispositif de commande d'un transistor, le dispositif comprenant :

- un ensemble de découpage propre à générer une première tension à partir d'une tension d'entrée continue, d'un premier signal de contrôle et d'un deuxième signal de contrôle, le premier signal de contrôle et le deuxième signal de contrôle étant chacun formé d'impulsions sans recouvrement temporel entre les impulsions desdits signaux de contrôle, la première tension étant formée :

  • d'impulsions d'amplitude égale à la tension d'entrée et en phase avec les impulsions du premier signal de contrôle et,
  • d'impulsion d'amplitude égale à l'opposé de la tension d'entrée et en phase avec les impulsions du deuxième signal de contrôle,

- un transformateur connecté à l'ensemble de découpage, le transformateur comprenant deux enroulements secondaires, les deux enroulements secondaires étant connectés l'un à l'autre en un point milieu, le premier enroulement secondaire étant propre à convertir la première tension pour obtenir une première tension convertie, le deuxième enroulement secondaire étant propre à convertir la première tension pour obtenir une deuxième tension convertie ($V_E$), chacune de la première et de la deuxième tension convertie étant formée :

  • d'impulsions d'amplitude de même signe que la première tension et en phase avec les impulsions de la première tension ayant une amplitude égale à la tension d'entrée, et
  • d'impulsions d'amplitude de signe opposé à la première tension et en phase avec les impulsions de la première tension ayant une amplitude égale à l'opposé de la tension d'entrée.

- un circuit de redressement propre à extraire les parties de même signe de la première tension convertie et de l'opposé de la deuxième tension convertie et à générer une troisième tension à partir des parties de même signe extraites,
- une bascule propre à générer une quatrième tension à partir des tensions converties, la quatrième tension présentant un état haut et un état bas, l'état haut étant déclenché en fonction du signe de l'amplitude de la première tension convertie, l'état bas étant déclenché en fonction du signe de l'amplitude de l'opposé de la deuxième tension convertie,
- un ensemble de commutation propre à multiplier la troisième tension avec l'état normalisé de la quatrième tension pour obtenir une tension multipliée, la tension multipliée présentant deux états correspondant aux états de la quatrième tension, l'un des états ayant une valeur égale à la troisième tension, l'autre état ayant une valeur nulle,
- un circuit de décalage propre à décaler l'amplitude de la tension multipliée pour obtenir une tension de commande du transistor, la tension de commande présentant :

  • une amplitude crête à crête égale à la troisième tension,
  • un état haut correspondant à l'état haut de la quatrième tension, et
  • un état bas correspondant à l'état bas de la quatrième tension et dans lequel la tension de commande est de signe opposé au signe de l'état haut de la tension de commande.

Suivant des modes de réalisation particuliers, le dispositif de commande comprend une ou plusieurs des caractéristiques suivantes, prises isolément ou suivant toutes les combinaisons techniquement possibles :

- chacun du circuit de redressement et de la bascule est relié directement au transformateur ;
- chacun du premier enroulement secondaire et du deuxième enroulement secondaire est propre à convertir la première tension en la multipliant par un même coefficient de multiplication ;

- le premier enroulement s'étend entre une première borne et le point milieu et le deuxième enroulement s'étend entre une deuxième borne et le point milieu, le circuit de redressement étant connecté au point milieu et à chacune de la première borne et de la deuxième borne, la bascule étant connectée à la première borne et de la deuxième borne ;
- le circuit de redressement comprend :

  - un redresseur propre à redresser la première tension convertie et l'opposé de la deuxième tension convertie pour obtenir une tension redressée, le redresseur comprenant une première diode et une deuxième diode, la première diode étant propre à redresser la première tension convertie, la deuxième diode étant propre à redresser l'opposé de la deuxième tension convertie, et
  - un condensateur propre à se charger pour obtenir la troisième tension.

- l'état haut de la quatrième tension est déclenché à l'instant des fronts montants des impulsions positives de la première tension convertie, l'état bas de la quatrième tension étant déclenché à l'instant des fronts montants des impulsions positives de l'opposé de la deuxième tension convertie ;
- la tension multipliée possède deux états, le circuit de décalage comprenant un condensateur et une diode Zener ; la diode Zener étant propre, dans l'un des états de la tension multipliée, à charger le condensateur à une cinquième tension égale à la troisième tension diminuée de la tension de la diode Zener, et à produire une tension de commande du transistor égale à la tension de la diode Zener ;
- la diode Zener est propre, dans l'autre état de la tension multipliée, à produire une tension de commande du transistor égale à l'opposé de la cinquième tension présente aux bornes du condensateur.

L'invention concerne aussi un convertisseur comprenant au moins un transistor et au moins un dispositif de commande du transistor tel que décrit précédemment.

L'invention concerne également un système embarqué comprenant un tel convertisseur.

D'autres caractéristiques et avantages de l'invention apparaîtront à la lecture de la description qui suit de modes de réalisation de l'invention, donnés à titre d'exemple uniquement, et en référence aux dessins qui sont :

- figure 1, un schéma bloc d'un exemple d'un transistor et d'un dispositif de commande du transistor,
- figure 2, une vue schématique d'un circuit électrique comprenant le transistor et le dispositif de commande du transistor de la figure 1,
- figure 3 et 4, un chronogramme d'un premier signal de contrôle, respectivement d'un deuxième signal de contrôle,
- figures 5 et 6, un chronogramme d'une première tension, respectivement d'une première et d'une deuxième tension convertie,
- figures 7 à 11, un chronogramme d'une troisième tension, respectivement d'une quatrième tension, respectivement d'une tension multipliée, respectivement d'une cinquième tension, respectivement d'une tension de commande, et
- figure 12, une vue schématique d'un système embarqué.

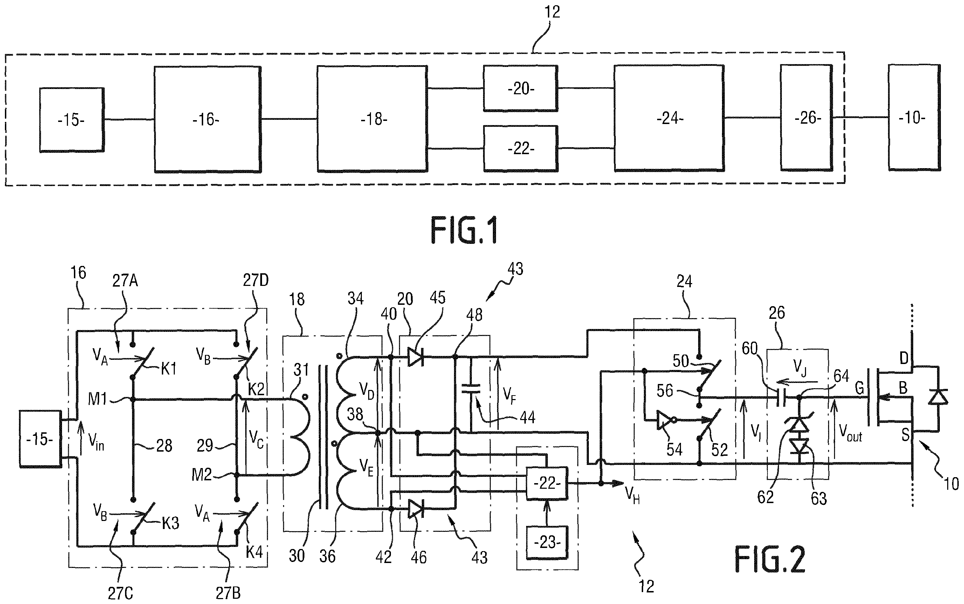

Un transistor 10 et un dispositif de commande 12 d'un tel transistor 10 sont illustrés par les figures 1 et 2.

Dans l'exemple illustré par la figure 2, le transistor 10 comprend une grille G, une source S, un drain D et une base B.

Le transistor 10 est, par exemple, un transistor MOSFET. Un tel transistor MOSFET est, par exemple, un transistor en silicium ou un transistor en carbure de silicium. Par rapport aux transistors en silicium, les transistors en carbure de silicium présentent une plus haute tenue en tension, une vitesse de commutation plus élevée, ainsi qu'une température de fonctionnement plus élevée.

Le dispositif de commande 12 est propre à générer une tension $V_{out}$ de commande du transistor 10 et, plus particulièrement, une tension $V_{out}$ de commande de la grille du transistor 10.

Le dispositif de commande 12 comprend, reliés successivement les uns aux autres, une source de tension 15, un ensemble de découpage 16, un transformateur 18, un circuit de redressement 20, une bascule 22, un ensemble de commutation 24 et un circuit de décalage 26.

La source de tension 15 est propre à délivrer une tension continue $V_{in}$ à l'entrée de l'ensemble de découpage 16.

L'ensemble de découpage 16 comprend un ensemble de commutateurs commandés par des signaux impulsionnels périodiques pour délivrer en sortie une première tension $V_C$. La première tension $V_C$ est formée d'impulsions successives d'amplitude alternativement égale à la tension d'entrée $V_{in}$ et égale à l'opposé de la tension d'entrée $V_{in}$.

En particulier, dans l'exemple de la figure 2, l'ensemble de découpage 16 comprend deux branches 28, 29 reliées en parallèle et alimentées par la tension d'entrée $V_{in}$. Les deux branches 28, 29 de l'ensemble de découpage 16 forment, ainsi, un pont, dit « pont en H ».

La première branche 28 comprend deux commutateurs K1 et K3 connectés en série en un point milieu M1. La deuxième branche 29 comprend deux commutateurs K2 et K4 connectés en série en un point milieu M2. Chaque commutateur K1, K2, K3, K4 est contrôlé par une entrée de contrôle 27A, 27B, 27C, 27D. Par exemple, lorsque les commutateurs K1, K2, K3, K4 sont des transistors à effet de champ, les entrées de contrôle 27A, 27B, 27C, 27D correspondent aux grilles desdits transistors.

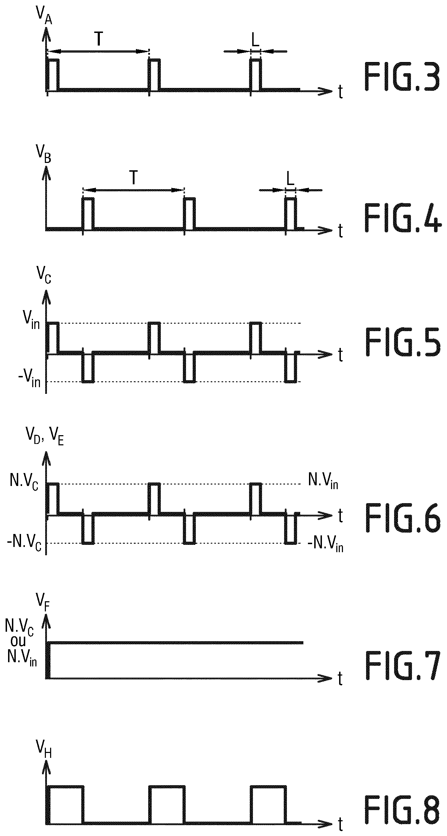

Les entrées de contrôle 27A, 27B du commutateur K1 de la première branche 28 et du commutateur K4 de la deuxième branche 29 sont commandées par un premier signal de contrôle $V_A$. Un exemple d'un chronogramme du premier signal de contrôle $V_A$ est illustré par la figure 3.

Les entrées de contrôle 27C, 27D du commutateur K3 de la première branche 28 et du commutateur K2 de la deuxième branche 29 sont commandées par un deuxième signal de contrôle $V_B$ Un exemple d'un chronogramme du deuxième signal de contrôle $V_B$ est illustré par la figure 4.

Le premier signal de contrôle $V_A$ et le deuxième signal de contrôle $V_B$ sont générés par un générateur d'impulsions.

Chacun du premier signal de contrôle $V_A$ et du deuxième signal de contrôle $V_B$ est formé d'impulsions de largeur constante L, se répétant avec une période constante T telle que le facteur de forme L/T de chaque impulsion soit strictement inférieur à 50 pourcents (%). Le facteur de forme d'une impulsion est le rapport de la largeur de l'impulsion à la période entre l'impulsion et une impulsion consécutive.

Le niveau haut des impulsions des signaux de contrôle $V_A$, $V_B$ correspond à l'état de fermeture du commutateur K1, K2, K3, K4 correspondant. Le niveau bas des impulsions des signaux de contrôle $V_A$, $V_B$ correspond à l'état d'ouverture du commutateur K1, K2, K3, K4 correspondant. Le premier signal de contrôle $V_A$ et le deuxième signal de contrôle $V_B$ sont décalés dans le temps l'un par rapport à l'autre de sorte qu'il n'y ait pas de recouvrement temporel entre les impulsions du premier signal de contrôle $V_A$ et du deuxième signal de contrôle $V_B$. Cela est nécessaire pour ne pas mettre la source de tension 15 en court-circuit.

En variante, le premier signal de contrôle $V_A$ et le deuxième signal de contrôle $V_B$ sont formés d'impulsions de largeurs différentes $L_A$ et $L_B$ et/ou de périodes de répétition d'impulsions différentes $T_A$ et $T_B$. Le premier signal de contrôle $V_A$ et le deuxième signal de contrôle $V_B$ sont décalés dans le temps l'un par rapport à l'autre de sorte qu'il n'y ait pas de recouvrement temporel entre les impulsions du premier signal de contrôle $V_A$ et du deuxième signal de contrôle $V_B$.

L'ensemble de découpage 16 est configuré pour délivrer la première tension $V_C$, illustré par la figure 2, à partir de la tension d'entrée $V_{in}$, du premier signal de contrôle $V_A$ et du deuxième signal de contrôle $V_B$.

La première tension $V_C$, illustrée par la figure 5, est formée :

- d'impulsions d'amplitude égale à la tension d'entrée $V_{in}$ et en phase avec les impulsions du premier signal de contrôle $V_A$, et

- d'impulsion d'amplitude égale à l'opposé de la tension d'entrée $V_{in}$ et en phase avec les impulsions du deuxième signal de contrôle $V_B$.

Ainsi, aux réponses transitoires près des commutateurs, la première tension $V_C$ s'exprime sous la forme de l'expression suivante :

$$V_C = V_{in}.V_{an} - V_{in}.V_{bn}$$

où

- $V_{in}$ est la tension d'entrée,
- $V_{an}$ est le premier signal de contrôle normalisé (valeur 0 ou 1), et
- $V_{bn}$ est le deuxième signal de contrôle normalisé (valeur 0 ou 1).

Le transformateur 18 est alimenté en entrée avec la première tension $V_C$.

Le transformateur 18 comprend un enroulement primaire 31 et deux enroulements secondaires 34, 36.

Il est entendu par le terme « enroulement », une bobine électrique.

L'enroulement primaire 31 est relié directement, d'une part, au point milieu M1 entre les commutateurs K1 et K3 de la première branche 28 de l'ensemble de découpage 16 et, d'autre part, au point milieu M2 entre les commutateurs K2 et K4 de la deuxième branche 29 de l'ensemble de découpage 16 de sorte à recevoir la première tension $V_C$.

Les enroulements secondaires 34 et 36 ont le même nombre de spires. Les enroulements secondaires 34 et 36 sont reliés l'un à l'autre en un point milieu 38.

Le premier enroulement secondaire 34 s'étend entre une première borne 40 et le point milieu 38. Le deuxième enroulement secondaire 36 s'étend entre une deuxième borne 42 et le point milieu 38.

Les deux enroulements secondaires 34, 36 ayant le même nombre de spires, chacun du premier enroulement secondaire 34 et du deuxième enroulement secondaire 36 en association avec l'enroulement primaire 31 est propre à convertir la première tension $V_C$ en multipliant l'amplitude de ladite première tension $V_C$ avec un même coefficient de multiplication N. Le coefficient de multiplication N est défini comme le rapport du nombre de spires de chaque enroulement secondaire 34, 36 du transformateur 18 au nombre de spires de l'enroulement primaire 31 du transformateur 18

Ainsi, le premier enroulement secondaire 34 en association avec l'enroulement primaire 31 est propre à convertir la première tension $V_C$ pour obtenir une première tension convertie $V_D$. Le deuxième enroulement 36 en association avec l'enroulement primaire 31 est propre à convertir la première tension $V_C$ pour obtenir une deuxième tension convertie $V_E$. Dans la mesure où le coefficient de multiplication N est le même pour chacun du premier et du deuxième enroulement 34, 36, la deuxième tension convertie $V_E$ est identique à la première tension convertie $V_D$. Un exemple d'un chronogramme de la première et de la deuxième tension convertie $V_D$, $V_E$ est illustré par la figure 6.

Chacune de la première et de la deuxième tension convertie $V_D$, $V_E$ est formée :

-    d'impulsions d'amplitude égale au coefficient de multiplication N multiplié par la première tension $V_C$ et en phase avec les impulsions de la première tension $V_C$ ayant une amplitude égale à la tension d'entrée $V_{in}$, et
-    d'impulsions d'amplitude égale au coefficient de multiplication N multiplié par l'opposé de la première tension $V_C$ et en phase avec les impulsions de la première tension $V_C$ ayant une amplitude égale à l'opposé de la tension d'entrée $V_{in}$.

Le circuit de redressement 20 est propre à extraire les parties de même signe de chaque tension convertie $V_D$, $V_E$ et à délivrer une troisième tension $V_F$ à partir des parties de même signe extraites. Par l'expression « parties de même signe », il est entendu la composante positive ou négative d'un signal.

La troisième tension $V_F$ est une tension continue d'amplitude égale à la valeur crête des parties de même signe de chaque tension convertie, et donc à la tension d'entrée $V_{in}$ multipliée par le coefficient de multiplication N du transformateur 18. Un exemple d'un chronogramme de la troisième tension $V_F$ est illustré par la figure 7.

Le circuit de redressement 20 est relié directement à chaque enroulement secondaire 34, 36 du transformateur 18. Ainsi, la tension de commande $V_{out}$ générée en sortie du dispositif 12 est isolée galvaniquement de la tension d'entrée $V_{in}$, et ce sans ajouter d'autres dispositifs d'isolement tels que des transformateurs additionnels ou des optocoupleurs.

Le circuit de redressement 20 comprend un redresseur 43 et un condensateur 44.

Le circuit de redressement 20 présente une borne connectée au point milieu 38 et une borne connectée à la première borne 40 de sorte à être alimenté par la première tension convertie $V_D$. Le circuit de redressement 20 présente, également, une borne connectée au point milieu 38 et une borne connectée à la deuxième borne 42 de sorte à être alimenté par la deuxième tension convertie $V_E$.

Le redresseur 43 est propre à redresser la tension convertie $V_D$ et l'opposé de la tension convertie $V_E$ et à charger le condensateur 44 pour obtenir une troisième tension $V_F$.

Le redresseur 43 comprend une première diode 45 et une deuxième diode 46.

L'anode de la première diode 45 est connectée à la première borne 40. L'anode de la deuxième diode 46 est connectée à la deuxième borne 42. Les cathodes de chacune de la première diode 45 et de la deuxième diode 46 sont reliées entre elles en un point de connexion 48.

La première diode 45 est propre à redresser la première tension convertie $V_D$. La deuxième diode 46 est propre à redresser l'opposé de la deuxième tension convertie $V_E$. En particulier, chacune des diodes 45, 46 ne laissant passer le courant que dans un sens, lesdites diodes 45, 46 fournissent à l'ensemble formé du condensateur 44 et de la charge en parallèle, une tension par rapport au point milieu 38 qui a un signe unique. Dans l'exemple illustré par la figure 2, l'orientation des diodes 45, 46 fait que ce sont les parties positives de la première tension convertie $V_D$ et de l'opposé de la deuxième tension convertie $V_E$ qui passent. Dans une variante dans laquelle les diodes 45, 46 seraient orientées dans le sens inverse, les parties négatives de la première tension convertie $V_D$ et de l'opposé de la deuxième tension convertie $V_E$ qui passeraient.

Le condensateur 44 est relié, d'une part, au point milieu 38 et, d'autre part, au point de connexion 48.

La bascule 22 est, par exemple, une bascule RS (abréviation de l'anglais « Reset » et « Set » traduit en français par « Désactivation » et « Activation »).

La bascule 22 est reliée directement au transformateur 18.

La bascule 22 comprend deux entrées et au moins une sortie.

La première entrée de la bascule 22 reçoit la première tension convertie $V_D$. La deuxième entrée de la bascule 22 reçoit la deuxième tension convertie $V_E$. La bascule 22 est, également, alimentée par une alimentation 23.

La bascule 22 est propre à délivrer en sortie une quatrième tension $V_H$ à partir des tensions converties $V_D$ et $V_E$. La quatrième tension $V_H$ est un signal logique présentant un état haut et un état bas. La première entrée de la bascule 22 permet de délivrer l'état haut de la quatrième tension $V_H$. La deuxième entrée de la bascule 22 permet de délivrer l'état bas de la quatrième tension $V_H$. Un exemple d'un chronogramme de la quatrième tension $V_H$ est illustré par la figure 8.

Dans l'exemple illustré par les figures, l'état haut de la quatrième tension $V_H$ est déclenché à l'instant des fronts montants des impulsions positives de la première tension convertie $V_D$. L'état bas de la quatrième tension $V_H$ est déclenché à l'instant des fronts montants des impulsions positives de l'opposé de la deuxième tension convertie $V_E$, c'est-à-dire des fronts montants des impulsions négatives de la deuxième tension convertie $V_E$.

L'ensemble de commutation 24 est propre à multiplier la troisième tension $V_F$ avec l'état normalisé de la quatrième tension $V_H$ pour obtenir une tension multipliée $V_I$.

L'ensemble de commutation 24 est connecté au circuit de redressement 20 de sorte à recevoir la troisième tension $V_F$. L'ensemble de commutation 24 est connecté à la bascule 22 de sorte à recevoir la quatrième tension $V_H$.

L'ensemble de commutation 24 comprend deux commutateurs 50, 52 et un amplificateur en inverse 54.

Les deux commutateurs 50, 52 sont reliés en série en un point milieu 56.

Le premier commutateur 50 comprend une entrée de contrôle dudit commutateur 50 recevant la quatrième tension $V_H$. Le deuxième commutateur 52 comprend une entrée de contrôle dudit deuxième commutateur 52 recevant l'opposé de la quatrième tension $V_H$, puisque l'inverseur 54 est connecté entre la sortie de la bascule 22 et l'entrée de contrôle du deuxième commutateur 52.

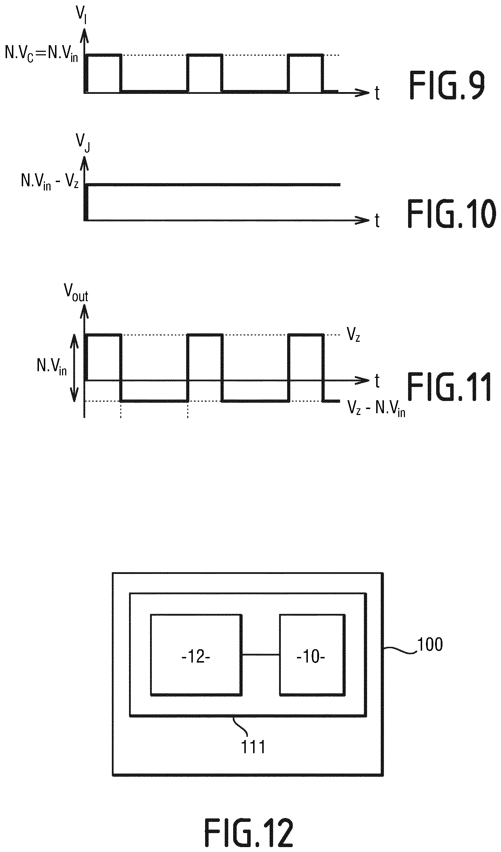

L'un des états de la quatrième tension $V_H$ rend passant (fermé) le commutateur 50 et non passant (ouvert) le commutateur 52. L'autre état de la quatrième tension $V_H$ rend non passant (ouvert) le commutateur 50 et passant (fermé) le commutateur 52. Par exemple, les états hauts de la quatrième tension $V_H$ rendent passant le commutateur 50 et non passant le commutateur 52, de sorte que la tension multipliée $V_I$ soit égale à la troisième tension $V_F$. Les états bas de la quatrième tension $V_H$ rendent non passant le commutateur 50 et passant le commutateur 52, de sorte que la tension multipliée $V_I$ soit égale à zéro. Un exemple d'un chronogramme de la tension multipliée $V_I$ est illustré par la figure 9.

Le circuit de décalage 26 est propre à décaler l'amplitude de la tension multipliée $V_I$ pour obtenir une tension $V_{out}$ de commande du transistor 10.

La tension de commande $V_{out}$ présente une amplitude crête-à-crête égale à la troisième tension $V_F$. En outre, la tension de commande $V_{out}$ présente : un état haut correspondant au premier état de la quatrième tension $V_H$ et un état bas correspondant au deuxième état de la quatrième tension $V_H$ et dans lequel la tension de commande $V_{out}$ est de signe opposé au signe de l'état haut.

Dans l'exemple illustré par la figure 2, le circuit de décalage 26 comprend un condensateur 60, une diode Zener 62 et une diode 63.

Le circuit de décalage 26 reçoit la tension multipliée $V_I$.

Le condensateur 60 présente une borne connectée en sortie de l'ensemble de commutation 24 au point milieu 56 entre les deux commutateurs 50, 52 et une borne connectée à la cathode de la diode Zener 62 en un point de connexion 64.

L'anode de la diode Zener 62 est connectée à l'anode de la diode 63. Ainsi, la diode Zener 62 et la diode 63 sont agencées tête-bêche.

La cathode de la diode 63 est connectée à la borne du condensateur 44 du circuit de redressement 20 qui est connectée au point milieu 38.

La diode 63 est propre à bloquer le passage du courant.

Lorsque le premier commutateur 50 est passant et le deuxième commutateur 52 est non passant, la tension multipliée $V_I$ est égale à la troisième tension $V_F$, le condensateur 60 se charge alors à une cinquième tension $V_J$ égale à la troisième tension $V_F$ diminuée de la tension $V_Z$ de la diode Zener 62 (à la tension de déchet près de la diode 63) et la tension de commande $V_{out}$ est égale à la tension $V_Z$ de la diode Zener (à la tension de déchet près de la diode 63). La tension $V_Z$ de la diode Zener 62 est continue.

Lorsque le premier commutateur 50 est non passant et le deuxième commutateur 52 est passant, la tension multipliée $V_I$ est nulle et la tension de commande $V_{out}$ est égale à l'opposé de la cinquième tension $V_J$, c'est-à-dire à la tension $V_Z$ de la diode Zener (à la tension de déchet près de la diode 63) moins la troisième tension $V_F$. La diode 63 permet d'éviter que le condensateur 60 ne se décharge dans la diode Zener 62 qui seule serait passante et court-circuiterait le condensateur 60.

Des exemples de chronogrammes de la cinquième tension $V_J$ et de la tension de commande $V_{out}$ sont illustrés respectivement par les figures 10 et 11.

L'explication précédente est donnée à titre d'exemple en négligeant la valeur de la tension de la diode 63. Si la tension de la diode 63 n'était pas négligée, l'explication précédente reste valable en remplaçant l'amplitude de la tension $V_Z$ de la diode Zener 62 par la somme des amplitudes de la tension $V_Z$ de la diode Zener 62 et de la tension de déchet de la diode 63.

Le fonctionnement du dispositif de commande 12 du transistor 10 va maintenant être décrit.

Initialement, l'ensemble de découpage 16 génère une première tension $V_C$ à partir de la tension d'entrée $V_{in}$, du premier signal de contrôle $V_A$ et du deuxième signal de contrôle $V_B$.

Ensuite, le premier enroulement secondaire 34 du transformateur 18 en association avec l'enroulement primaire 31 convertit la première tension $V_C$ pour obtenir une première tension convertie $V_D$. De même, le deuxième enroulement secondaire 36 du transformateur 18 en association avec l'enroulement primaire 31 convertit la première tension $V_C$ pour obtenir une deuxième tension convertie $V_E$.

Puis, le circuit de redressement 20 extrait les parties de même signe de chaque tension convertie $V_D$, $-V_E$ et délivre une troisième tension $V_F$ à partir des parties de même signe extraites. En particulier, le redresseur 43 redresse la tension convertie $V_D$ et l'opposé de la tension convertie $V_E$ pour obtenir la troisième tension $V_F$. Le condensateur 44 se charge à la troisième tension $V_F$.

En parallèle, la bascule 22 délivre une quatrième tension $V_H$ à partir des signaux convertis $V_D$ et $-V_E$.

Ensuite, l'ensemble de commutation 24 multiplie la troisième tension $V_F$ avec l'état normalisé (0 ou 1) de la quatrième tension $V_H$ pour obtenir une tension multipliée $V_I$.

Enfin, le circuit de décalage 26 décale l'amplitude de la tension multipliée $V_I$ pour obtenir une tension $V_{out}$ de commande du transistor 10. En particulier, le condensateur 60 du circuit de décalage 26 se charge à une cinquième tension $V_J$ égale à la troisième tension $V_F$ diminuée de la tension $V_Z$ de la diode Zener 62, permettant d'obtenir une tension $V_{out}$ de commande du transistor 10 avec deux états $V_Z$ et $V_Z$-$V_F$.

Ainsi, le dispositif de commande 12 permet de choisir le décalage en tension de la tension de commande $V_{out}$ de sorte à obtenir une tension de commande $V_{out}$ symétrique ou asymétrique en fonction du transistor 10 commandé. Cela permet de s'affranchir des problèmes existants avec les dispositifs de commande actuels qui sont non adaptés pour commander des transistors requérant une tension de commande asymétrique, tels que les transistors en carbure de silicium.

En outre, le dispositif de commande 12 présente une basse impédance vis-à-vis de la grille du transistor 10 et cela, quelle que soit la phase de commande du transistor 10. Le dispositif de commande 12 est, ainsi, moins sensible aux risques de perturbations par couplage parasite, susceptibles d'affecter l'état de la charge de la grille de transistor 10.

De plus, le transformateur 18 du dispositif de commande 12 ne charge pas directement la grille du transistor 10 mais passe par l'intermédiaire d'un composant tampon qui est le condensateur 44 du circuit de redressement 20, ce qui permet de désensibiliser le dispositif de commande 12 des phénomènes de résonance.

Le dispositif de commande 12 présente également un nombre de composants relativement limité, ce qui permet de conserver un dispositif de commande 12 suffisamment compact. En particulier, le dispositif de commande 12 permet la transmission de la puissance et de la commande en parallèle via le transformateur 18 à point milieu 38 sans utiliser d'autres composants, tels que des optocoupleurs ou des transformateurs additionnels pour transmettre la commande.

La figure 12 illustre en complément un système embarqué 100, tel qu'un aéronef, comprenant un convertisseur 111. Le convertisseur 111 comprend le transistor 10 et le dispositif de commande 12 du transistor 10.

## Revendications

**1.** Dispositif de commande (12) d'un transistor (10), le dispositif (12) comprenant :

- un ensemble de découpage (16) propre à générer une première tension ($V_C$) à partir d'une tension d'entrée ($V_{in}$) continue, d'un premier signal de contrôle ($V_A$) et d'un deuxième signal de contrôle ($V_B$), le premier signal de contrôle ($V_A$) et le deuxième signal de contrôle ($V_B$) étant chacun formé d'impulsions sans recouvrement temporel entre les impulsions desdits signaux de contrôle ($V_A$, $V_B$), la première tension ($V_C$)

étant formée :

• d'impulsions d'amplitude égale à la tension d'entrée ($V_{in}$) et en phase avec les impulsions du premier signal de contrôle ($V_A$) et,
• d'impulsion d'amplitude égale à l'opposé de la tension d'entrée ($V_{in}$) et en phase avec les impulsions du deuxième signal de contrôle ($V_B$),

- un transformateur (18) connecté à l'ensemble de découpage (16), le transformateur (18) comprenant deux enroulements secondaires (34, 36), les deux enroulements secondaires (34, 36) étant connectés l'un à l'autre en un point milieu (38), le premier enroulement secondaire (34) étant propre à convertir la première tension ($V_C$) pour obtenir une première tension convertie ($V_D$), le deuxième enroulement secondaire (36) étant propre à convertir la première tension ($V_C$) pour obtenir une deuxième tension convertie ($V_E$), chacune de la première et de la deuxième tension convertie ($V_D$, $V_E$) étant formée :

• d'impulsions d'amplitude de même signe que la première tension ($V_C$) et en phase avec les impulsions de la première tension ($V_C$) ayant une amplitude égale à la tension d'entrée ($V_{in}$), et
• d'impulsions d'amplitude de signe opposé à la première tension ($V_C$) et en phase avec les impulsions de la première tension ($V_C$) ayant une amplitude égale à l'opposé de la tension d'entrée ($V_{in}$).

- un circuit de redressement (20) propre à extraire les parties de même signe de la première tension convertie ($V_D$) et de l'opposé de la deuxième tension convertie ($V_E$) et à générer une troisième tension ($V_F$) à partir des parties de même signe extraites,
- une bascule (22) propre à générer une quatrième tension ($V_H$) à partir des tensions converties ($V_D$, $V_E$), la quatrième tension ($V_H$) présentant un état haut et un état bas, l'état haut étant déclenché en fonction du signe de l'amplitude de la première tension convertie ($V_D$), l'état bas étant déclenché en fonction du signe de l'amplitude de l'opposé de la deuxième tension convertie ($V_E$),
- un ensemble de commutation (24) propre à multiplier la troisième tension ($V_F$) avec l'état normalisé de la quatrième tension ($V_H$) pour obtenir une tension multipliée ($V_I$), la tension multipliée ($V_I$) présentant deux états correspondant aux états de la quatrième tension ($V_H$), l'un des états ayant une valeur égale à la troisième tension ($V_F$), l'autre état ayant une valeur nulle, et
- un circuit de décalage (26) propre à décaler l'amplitude de la tension multipliée ($V_I$) pour obtenir une tension de commande ($V_{out}$) du transistor (10), la tension de commande ($V_{out}$) présentant :

• une amplitude crête à crête égale à la troisième tension ($V_F$),
• un état haut correspondant à l'état haut de la quatrième tension ($V_H$), et
• un état bas correspondant à l'état bas de la quatrième tension ($V_H$) et dans lequel la tension de commande ($V_{out}$) est de signe opposé au signe de l'état haut de la tension de commande ($V_{out}$).

2. Dispositif (12) selon la revendication 1, dans lequel chacun du circuit de redressement (20) et de la bascule (22) est relié directement au transformateur (18).

3. Dispositif (12) selon la revendication 1 ou 2, dans lequel chacun du premier enroulement secondaire (34) et du deuxième enroulement secondaire (36) est propre à convertir la première tension ($V_C$) en la multipliant par un même coefficient de multiplication (N).

4. Dispositif (12) selon l'une quelconque des revendications 1 à 3, dans lequel le premier enroulement (34) s'étend entre une première borne (40) et le point milieu (38) et le deuxième enroulement (36) s'étend entre une deuxième borne (42) et le point milieu (38), le circuit de redressement (20) étant connecté au point milieu (38) et à chacune de la première borne (40) et de la deuxième borne (42), la bascule (22) étant connectée à la première borne (40) et de la deuxième borne (42).

5. Dispositif (12) selon l'une quelconque des revendications 1 à 4, dans lequel le circuit de redressement (20) comprend :

- un redresseur (43) propre à redresser la première tension convertie ($V_D$) et l'opposé de la deuxième tension convertie ($V_E$) pour obtenir une tension redressée ($V_F$), le redresseur (43) comprenant une première diode (45) et une deuxième diode (46), la première diode (45) étant propre à redresser la première tension convertie ($V_D$), la deuxième diode (46) étant propre à redresser l'opposé de la deuxième tension convertie ($V_E$), et
- un condensateur (44) propre à se charger pour obtenir la troisième tension ($V_F$).

6. Dispositif (12) selon l'une quelconque des revendications 1 à 5, dans lequel l'état haut de la quatrième tension ($V_H$) est déclenché à l'instant des fronts montants des impulsions positives de la première tension convertie ($V_D$), l'état bas de la quatrième tension ($V_H$) étant déclenché à l'instant des fronts montants des impulsions positives de l'opposé de la deuxième tension convertie ($V_E$).

7. Dispositif (12) selon l'une quelconque des revendications 1 à 6, dans lequel la tension multipliée ($V_I$) possède deux états, le circuit de décalage (26) comprenant un condensateur (60) et une diode Zener (62) ; la diode Zener (62) étant propre, dans l'un des états de la tension multipliée ($V_I$), à charger le condensateur (60) à une cinquième tension ($V_J$) égale à la troisième tension ($V_F$) diminuée de la tension ($V_Z$) de la diode Zener (62), et à produire une tension de commande ($V_{out}$) du transistor (10) égale à la tension ($V_Z$) de la diode Zener (62).

8. Dispositif (12) selon la revendication 7, dans lequel la diode Zener (62) est propre, dans l'autre état de la tension multipliée ($V_I$), à produire une tension de commande ($V_{out}$) du transistor (10) égale à l'opposé de la cinquième tension ($V_J$) présente aux bornes du condensateur (60).

9. Convertisseur comprenant au moins un transistor (10) et au moins un dispositif de commande (12) du transistor (10) selon l'une quelconque des revendications 1 à 8.

10. Système embarqué comprenant un convertisseur selon la revendication 9.

**Patentansprüche**

1. Vorrichtung (12) zum Steuern eines Transistors (10), wobei die Vorrichtung (12) umfasst:

- eine Zerhackeranordnung (16), die geeignet ist, eine erste Spannung (Vc) aus einer Eingangsgleichspannung ($V_{in}$), einem ersten Steuersignal ($V_A$) und einem zweiten Steuersignal ($V_B$) zu erzeugen, wobei das erste Steuersignal ($V_A$) und das zweite Steuersignal ($V_B$) jeweils aus Impulsen ohne zeitlicher Überdeckung zwischen den Impulsen der Steuersignale ($V_A$, $V_B$) gebildet sind, wobei die erste Spannung (Vc) gebildet ist aus:

• Impulsen einer Amplitude gleich der Eingangsspannung ($V_{in}$) und in Phase mit den Impulsen des ersten Steuersignals ($V_A$) und
• Impulsen einer Amplitude entgegengesetzt gleich der Eingangsspannung ($V_{in}$) und in Phase mit den Impulsen des zweiten

8

Steuersignals ($V_B$),

- einen Transformator (18), der mit der Zerhackeranordnung (16) verbunden ist, wobei der Transformator (18) zwei Sekundärwicklungen (34, 36) enthält und die zwei Sekundärwicklungen (34, 36) miteinander an einem Mittelpunkt (38) verbunden sind, wobei die erste Sekundärwicklung (34) geeignet ist, die erste Spannung (Vc) umzuwandeln, um eine erste umgewandelte Spannung ($V_D$) zu erhalten und die zweite Sekundärwicklung (36) geeignet ist, die erste Spannung (Vc) umzuwandeln, um eine zweite umgewandelte Spannung ($V_E$) zu erhalten, wobei jede der ersten und zweiten umgewandelten Spannung ($V_D$, $V_E$) gebildet ist aus:

    • Impulsen einer Amplitude mit gleichem Vorzeichen wie die erste Spannung (Vc) und in Phase mit den Impulsen der ersten Spannung (Vc), die eine Amplitude gleich der Eingangsspannung ($V_{in}$) aufweist und
    • Impulsen einer Amplitude mit entgegengesetztem Vorzeichen zu dem der ersten Spannung (Vc) und in Phase mit den Impulsen der ersten Spannung (Vc), die eine Amplitude entgegengesetzt gleich der Eingangsspannung ($V_{in}$) aufweist,

- eine Gleichrichterschaltung (20), die geeignet ist, die Teile gleichen Vorzeichens der ersten umgewandelten Spannung ($V_D$) und dem Entgegengesetzten der zweiten umgewandelten Spannung ($V_E$) zu extrahieren und eine dritte Spannung ($V_F$) aus den extrahierten Teilen gleichen Vorzeichens zu erzeugen,
- eine Kippschaltung (22), die geeignet ist, eine vierte Spannung ($V_H$) aus den umgewandelten Spannungen ($V_D$, $V_E$) zu erzeugen, wobei die vierte Spannung ($V_H$) einen High-Zustand und einen Low-Zustand aufweist und der High-Zustand abhängig von dem Vorzeichen der Amplitude des ersten umgewandelten Signals ($V_D$) ausgelöst wird und der Low-Zustand abhängig vom Vorzeichen der Amplitude des Entgegengesetzten der zweiten umgewandelten Spannung ($V_E$) ausgelöst wird,
- eine Schalteranordnung (24), die geeignet ist, die dritte Spannung ($V_F$) mit dem normalisierten Zustand der vierten Spannung ($V_H$) zu multiplizieren, um eine multiplizierte Spannung ($V_I$) zu erhalten, wobei die multiplizierte Spannung ($V_I$) zwei Zustände entsprechend den Zuständen der vierten Spannung ($V_H$) aufweist und einer der Zustände einen Wert gleich der dritten Spannung ($V_F$) hat und der andere Zustand einen Wert Null hat und
- eine Versetzungsschaltung (26), die geeignet ist, die Amplitude der multiplizierten Spannung ($V_I$) zu verschieben, um eine Steuerspannung ($V_{out}$) des Transistors (10) zu erhalten, wobei die Steuerspannung ($V_{out}$) aufweist:

    • eine Amplitude Spitze-zu-Spitze gleich der dritten Spannung ($V_F$)
    • einen High-Zustand entsprechend dem High-Zustand der vierten Spannung ($V_H$) und
    • einen Low-Zustand entsprechend dem Low-Zustand der vierten Spannung ($V_H$) und bei dem die Steuerspannung ($V_{out}$) ein Vorzeichen entgegengesetzt zum Vorzeichen des High-Zustands der Steuerspannung ($V_{out}$) aufweist.

2. Vorrichtung (12) nach Anspruch 1, bei der jede der Gleichrichterschaltung (20) und der Kippschaltung (22) direkt an den Transformator (18) angeschlossen ist.

3. Vorrichtung (12) nach Anspruch 1 oder 2, bei der jede der ersten Sekundärwicklung (34) und der zweiten Sekundärwicklung (36) geeignet ist, die erste Spannung (Vc) umzuwandeln, indem sie mit einem selben Multiplikationskoeffizienten (N) multipliziert wird.

4. Vorrichtung (12) nach einem beliebigen der Ansprüche 1 bis 3, bei der die erste Wicklung (34) sich zwischen einem ersten Anschlusspunkt (40) und dem Mittelpunkt (38) erstreckt und die zweite Wicklung (36) sich zwischen einem zweiten Anschlusspunkt (42) und dem Mittelpunkt (38) erstreckt, wobei die Gleichrichterschaltung (20) an den Mittelpunkt (38) und einen jeden des ersten Anschlusspunktes (40) und des zweiten Anschlusspunktes (42) angeschlossen ist und die Kippschaltungen (22) mit dem ersten Anschlusspunkt (40) und dem zweiten Anschlusspunkt (42) verbunden ist.

5. Vorrichtung (12) nach einem beliebigen der Ansprüche 1 bis 4, bei der die Gleichrichterschaltung (20) umfasst:

    - einen Gleichrichter (43), der geeignet ist, die erste umgewandelte Spannung ($V_D$) und das Entgegengesetzte der zweiten umgewandelten Spannung ($V_E$) gleichzurichten, um eine gleichgerichtete Spannung ($V_F$) zu erhalten, wobei der Gleichrichter (43) eine erste Diode (49) und eine zweite Diode (46) umfasst und die erste Diode (45) geeignet ist, die erste umgewandelte Spannung ($V_D$) gleichzurichten und die zweite Diode (46) geeignet ist, das Entgegengesetzte der zweiten umgewandelten Spannung ($V_E$) gleichzurichten, und

- einen Kondensator (44), der geeignet ist, sich aufzuladen, um die dritte Spannung ($V_F$) zu erhalten.

**6.** Vorrichtung (12) nach einem beliebigen der Ansprüche 1 bis 5, bei der der High-Zustand der vierten Spannung ($V_H$) zum Zeitpunkt der ansteigenden Flanken der positiven Impulse der ersten umgewandelten Spannung ($V_D$) ausgelöst wird und der Low-Zustand der vierten Spannung ($V_H$) zum Zeitpunkt der ansteigenden Flanken der positiven Impulse des Entgegengesetzten der zweiten umgewandelten Spannung ($V_E$) ausgelöst wird.

**7.** Vorrichtung (12) nach einem beliebigen der Ansprüche 1 bis 6, bei der die multiplizierte Spannung ($V_I$) zwei Zustände besitzt, die Versetzungsschaltung (26) einen Kondensator (60) und eine Zenerdiode (62) umfasst; wobei die Zenerdiode (62) geeignet ist, in einem der Zustände der multiplizierten Spannung ($V_I$) den Kondensator (60) auf eine fünfte Spannung ($V_J$) gleich der dritten Spannung ($V_F$), verringert um die Spannung ($Vz$) der Zenerdiode (62) aufzuladen und eine Steuerspannung ($V_{out}$) des Transistors (10) gleich der Spannung ($Vz$) der Zenerdiode (62) zu erzeugen.

**8.** Vorrichtung (12) nach Anspruch 7, bei der die Zenerdiode (62) geeignet ist, in dem anderen Zustand der multiplizierten Spannung($V_I$) eine Steuerspannung ($V_{out}$) des Transistors (10) entgegengesetzt gleich der an den Klemmen des Kondensators (60) vorhandenen fünften Spannung ($V_J$) zu erzeugen.

**9.** Wandler, der mindestens einen Transistor (10) und mindestens eine Steuervorrichtung (12) des Transistors (10) nach einem beliebigen der Ansprüche 1 bis 8 umfasst.

**10.** Mitgeführtes System, das einen Wandler nach Anspruch 9 aufweist.

**Claims**

**1.** A device (12) for controlling a transistor (10), the device (12) comprising:

- a separating assembly (16) for generating a first voltage ($V_C$) from a DC input voltage ($V_{in}$), a first control signal ($V_A$) and a second control signal ($V_B$), the first control signal ($V_A$) and the second control signal ($V_B$) each being formed by pulses with no temporal overlap between the pulses of said control signals ($V_A$, $V_B$), the first voltage ($V_C$) being formed by:

    • pulses of amplitude equal to the input voltage ($V_{in}$) and in phase with the pulses of the first control signal ($V_A$), and
    • pulse of amplitude equal to the opposite of the input voltage ($V_{in}$) and in phase with the pulses of the second control signal ($V_B$),

- a transformer (18) connected to the separating assembly (16), the transformer (18) comprising two secondary windings (34, 36), the two secondary windings (34, 36) being connected to one another at a midpoint (38), the first secondary winding (34) being able to convert the first voltage ($V_C$) to obtain a first converted voltage ($V_D$), the second secondary winding (36) being able to convert the first voltage ($V_C$) to obtain a second converted voltage ($V_E$), each of the first and second converted voltage ($V_D$, $V_E$) being formed by:

    • pulses of amplitude with the same sign as the first voltage ($V_C$) and in phase with the pulses of the first voltage ($V_C$) having an amplitude equal to the input voltage ($V_{in}$), and
    • pulses of amplitude with the opposite sign from the first voltage ($V_C$) and in phase with the pulses of the first voltage ($V_C$) having an amplitude equal to the opposite of the input voltage ($V_{in}$),

- a rectifier circuit (20) able to extract the parts of the same sign from the first converted voltage ($V_D$) and of opposite sign from the second converted voltage ($V_E$) and to generate a third voltage ($V_F$) from the extracted parts of the same sign,
- a latch (22) able to generate a fourth voltage ($V_H$) from the converted voltages ($V_D$, $V_E$), the fourth voltage ($V_H$) having a high state and a low state, the high state being triggered as a function of the sign of the amplitude of the first converted voltage ($V_D$), the low state being triggered as a function of the sign of the amplitude of the opposite of the second converted voltage ($V_E$),
- a switching assembly (24) able to multiply the third voltage ($V_F$) by the normalized state of the fourth voltage ($V_H$) to obtain a multiplied voltage ($V_I$), the multiplied voltage ($V_I$) having two states corresponding to the states of the fourth voltage ($V_H$), one of the states having a value equal to the third voltage ($V_F$), the other state having a nil value, and
- a shifting circuit (26) able to shift the amplitude of the multiplied voltage ($V_I$) to obtain a control voltage ($V_{out}$) of the transistor (10), the control voltage ($V_{out}$) having:

    • a peak-to-peak amplitude equal to the third voltage ($V_F$),

 • a high state corresponding to the high state of the fourth voltage ($V_H$), and

 • a low state corresponding to the low state of the fourth voltage ($V_H$) and in which the sign of the control voltage ($V_{out}$) is opposite the sign of the high state of the control voltage ($V_{out}$).

2. The device (12) according to claim 1, wherein each of the rectifier circuit (20) and the latch (22) is directly connected to the transformer (18).

3. The device (12) according to claim 1 or 2, wherein each of the first secondary winding (34) and the second secondary winding (36) is able to convert the first voltage ($V_C$) by multiplying it by a same multiplication coefficient ($N$).

4. The device (12) according to any one of claims 1 to 3, wherein the first winding (34) extends between a first terminal (40) and the midpoint (38) and the second winding (36) extends between a second terminal (42) and the midpoint (38), the rectifier circuit (20) being connected to the midpoint (38) and each of the first terminal (40) and the second terminal (42), the latch (22) being connected to the first terminal (40) and the second terminal (42).

5. The device (12) according to any one of claims 1 to 4, wherein the rectifier circuit (20) comprises:

 - a rectifier (43) able to rectify the first converted voltage ($V_D$) and the opposite of the second converted voltage ($V_E$) to obtain a rectified voltage ($V_F$), the rectifier (43) comprising a first diode (45) and a second diode (46), the first diode (45) being able to rectify the first converted voltage ($V_D$), the second diode (46) being able to rectify the opposite of the second converted voltage ($V_E$), and
 - a capacitor (44) able to charge itself to obtain the third voltage ($V_F$).

6. The device (12) according to any one of claims 1 to 5, wherein the high state of the fourth voltage ($V_H$) is triggered during rising edges of the positive pulses of the converted first voltage ($V_D$), the low state of the fourth voltage ($V_H$) being triggered during rising edges of the positive pulses of the opposite of the converted second voltage ($V_E$).

7. The device (12) according to any one of claims 1 to 6, wherein the multiplied voltage ($V_I$) has two states, the shifting circuit (26) comprising a capacitor (60) and a Zener diode (62); the Zener diode (62) being able, in one of the states of the multiplied voltage ($V_I$), to charge the capacitor (60) to a fifth voltage

($V_J$) equal to the third voltage ($V_F$) decreased by the voltage of the Zener diode (62), and to produce a control voltage ($V_{out}$) of the transistor (10) equal to the voltage ($V_Z$) of the Zener diode (62).

8. The device (12) according to claim 7, wherein the Zener diode (62) is able, in the other state of the multiplied voltage ($V_I$), to produce a control voltage ($V_{out}$) of the transistor (10) equal to the opposite of the fifth voltage ($V_J$) present across the terminals of the capacitor (60).

9. A converter comprising at least one transistor (10) and at least one device (12) for controlling the transistor (10) according to any one of claims 1 to 8.

10. An on-board system comprising a converter according to claim 9.

FIG.1

FIG.2

$V_A$

T

L

FIG.3

t

$V_B$

T

L

FIG.4

t

$V_C$

$V_{in}$

$-V_{in}$

FIG.5

t

$V_D, V_E$

$N.V_C$

$N.V_{in}$

$-N.V_C$

$-N.V_{in}$

FIG.6

t

$V_F$

$N.V_C$
ou
$N.V_{in}$

FIG.7

t

$V_H$

FIG.8

t

$V_I$

$N.V_C = N.V_{in}$

t

# FIG.9

$V_J$

$N.V_{in} - V_z$

t

# FIG.10

$V_{out}$

$V_z$

$N.V_{in}$

t

$V_z - N.V_{in}$

# FIG.11

-12-   -10-   100

111

# FIG.12

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 3243660 A1